# EUROPEAN PATENT APPLICATION

(11) **EP 2 829 634 A1**
(43) Date of publication of application: **28.01.2015**
(21) Application number: 13764419.1
(22) Date of filing: 31.01.2013
(51) Int. Cl.: C23C 14/24, C23C 14/00, C23C 14/06, C23C 14/22

(54) **APPARATUS FOR FORMING COMPLEX NANOPARTICLE FILM AND METHOD FOR FORMING NANOPARTICLE FILM USING SAME**

(30) Priority: 22.03.2012 JP 2012065703
(71) Applicant: Kabushiki Kaisha Atsumitec, Shizuoka 433-8118 (JP)
(72) Inventor: UCHIYAMA, Naoki, Hamamatsu-shi Shizuoka 433-8118 (JP); KANAI, Tomomi, Hamamatsu-shi Shizuoka 433-8118 (JP)
(74) Representative: MERH-IP Matias Erny Reichl Hoffmann
(86) International application number: PCT/JP2013/052197
(87) International publication number: WO 2013/140863

(57) **Abstract**

A multinary nanoparticle film forming system (1) includes: a generating chamber (2) with a plurality of metal materials (4a to 4c) arranged therein so as to generate multinary nanoparticles (9) from nanoparticles (8a to 8c); a film forming chamber (3) with a substrate (7) arranged therein; and granulation units (11a to 11c) arranged in the generating chamber (2) so as to respectively correspond to the plurality of metal materials (4a to 4c). Further, each of the granulation units (11a to 11c) includes each of containers (12a to 12c) respectively covering the metal materials (4a to 4c), each of heaters (15a to 15c) respectively arranged in the containers (12a to 12c), each of outflow ports respectively provided at the containers (12a to 12c) so as to enable the nanoparticles (8a to 8c) to flow out therefrom, and each of inflow ports (14a to 14c) respectively provided at the containers (12a to 12c) so as to enable the coolant gas to be respectively introduced into the containers (12a to 12c).

## Description

### Technical Field

The present invention relates to an system for forming a multinary nanoparticle film and a method for forming a nanoparticle film using the same.

### Background Art

An ultrafine particle film forming method and an ultrafine particle film forming system are described in Patent Document 1. In this system, vapor atoms are generated from a material and then are moved through a carrying pipe together with inert gas, so that an ultrafine particle film is formed on a substrate. In other words, the configuration of the ultrafine particle film forming system and method are expressed in general as follows: upper and lower chambers are installed so as to communicate with each other by a narrow pipe. Then, the upper chamber is vacuumed, and coolant gas is made to flow into the lower chamber. Then, evaporated metal is cooled, so as to be moved to the upper chamber by a pressure difference. Then, the metal is collected in a particle state on a substrate in the upper chamber. The coolant gas is helium gas or argon gas, for example, and when the coolant gas is made to flow, aggregation and grain growth of the particles during the movement are prevented.

However, in a case where the system described in Patent Document 1 is used to evaporate a plurality of metal materials so as to form a multinary metal nanoparticle film on a substrate, the evaporation pressure and the particle mass are different for each kind of the metal materials, and hence the rate and amount of each of the metal particles accumulated on the substrate are different for each of the metal particles. For example, in a case where materials of Mg and Ni are arranged in the lower chamber and evaporated under a same condition, the material of Mg having high evaporation pressure is evaporated by being slightly heated, and the amount of evaporation of the material of Ni is limited to be small. As a result, a film mostly made of Mg particles is formed on the substrate. Further, there is a case where a metal material thermally affects the other metal material, and hence there is also a restriction on the arrangement positions of metal materials, such as a restriction that a metal material having a low melting point cannot be arranged next to a metal material having a high melting point. Therefore, when desired multinary metal nanoparticles are to be obtained, it is difficult to control the temperature of particles and also to adjust the diameter and amount of particles.

### Prior Art Document

### Patent Document

Patent Document 1: Japanese Patent Application Laid-Open Publication No. 2000-297361

### Summary of the Invention

### Problems to be solved by the Invention

The present invention has been made in view of the above-described prior art techniques. An object of the invention is to provide a multinary nanoparticle film forming system and a multinary nanoparticle film forming method using the multinary nanoparticle film forming system in which a suitable amount of nanoparticles having a suitable diameter can be generated for each of a plurality of metal materials regardless of evaporation pressure of each of the metal materials and without the thermal influence between the plurality of metal materials, and in which a film of the multinary nanoparticles can be formed on a substrate.

### Means for Solving the Problems

In order to achieve the above described object, the present invention is to provide a multinary nanoparticle film forming system which is featured by including: a generating chamber with a plurality of metal materials arranged therein so as to generate multinary nanoparticles from nanoparticles formed from each of the plurality of metal materials; a film forming chamber with a substrate arranged therein so as to enable a film of the multinary nanoparticles to be formed on the substrate; a communication pipe configured to connect the generating chamber to the film forming chamber; an exhaust unit configured to carry out exhaust from the film forming chamber; a coolant-gas introduction unit configured to introduce coolant gas into the generating chamber; and granulation units arranged in the generating chamber so as to respectively correspond to the plurality of metal materials, the multinary nanoparticle film forming system being featured in that the granulation unit includes containers respectively covering the metal materials, a heater arranged in the container, an outflow port provided at the container so as to enable the nanoparticles to flow out therefrom, and an inflow port provided at the container so as to enable the coolant gas to be introduced into the container.

It is preferred that the capacity of the container and the distance from the outflow port to the communication pipe are made different for each of the metal materials.

Further, the present invention is also to provide a multinary nanoparticle film forming method using the multinary nanoparticle film forming system, the method being featured by including: a nanoparticle generation process of generating nanoparticles from the metal material in each of the granulation units; an alloying process of generating multinary nanoparticles by combining the plurality of kinds of nanoparticles in the generating chamber; and a film forming process of passing the multinary nanoparticles through the communication pipe and forming a film of the multinary nanoparticles on the substrate in the film forming chamber.

It is preferred that, in the nanoparticle generation process, the heating temperature by the heater, and the amount of the coolant gas introduced into the container are adjusted to be different for each of the metal materials respectively arranged in the granulation units.

### Advantageous Effects of the Invention

According to the present invention, the granulation unit is provided independently for each of the metal materials arranged in the generating chamber, and hence it is possible to obtain nanoparticles by evaporating each of the metal materials under conditions suitable for each of the metal materials. Therefore, multinary nanoparticles can be formed on the substrate in such a manner that, regardless of the evaporation pressure different for each of the plurality of metal materials, a suitable amount of nanoparticles having a suitable diameter can be generated for each of the metal materials without being thermally affected by the other metal materials.

Further, the capacity of the container is optimized for each of the metal material, and thereby it is possible to evaporate each of the metal materials at an evaporation pressure suitable for each of the metal materials. Further, the distance from the outflow port to the communication pipe is optimized for each of the metal materials, and thereby it is possible to adjust the difference in the moving speed of each of the metal material due to the mass of each of the metal materials.

Further, in the nanoparticle production process, each kind of nanoparticles are generated by evaporating each of the metal materials in each of the granulation units, and hence each kind of the nanoparticles can be generated from each of the metal materials under conditions suitable for each of the metal materials without being thermally affected from the other metal materials and regardless of the differences in the weight and evaporation pressure of each of the metal materials.

Further, the heater is also independently provided in each of the granulation units, and the heating temperatures of the respective heaters are adjusted to be different from each other. Thereby, it is possible to heat each of the metal materials at a temperature suitable for each of the metal materials. Further, the introduction amount of the coolant gas is adjusted to be different for each of the granulation units, and hence it is possible to perform the coolant operation suitable for each of the metal materials.

### Brief Description of the Drawings

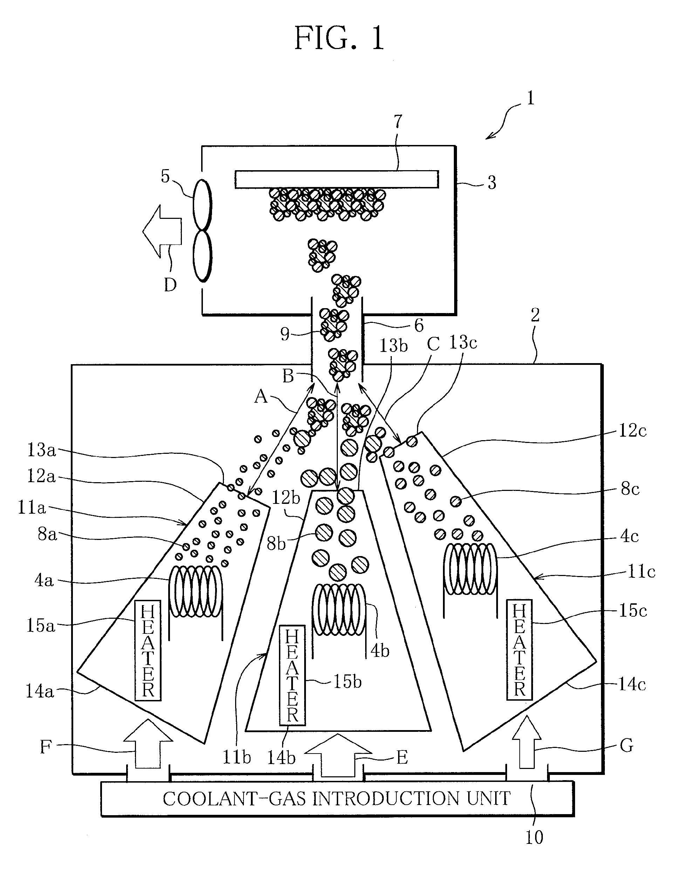

FIG. 1 is a schematic view of a nanoparticle film forming system according to the present invention.

### Mode for Carrying out the Invention

As shown in FIG. 1, a nanoparticle film forming system 1 according to the present invention includes a generating chamber 2 and a film forming chamber 3. A plurality of metal materials (three metal materials 4a to 4c in FIG. 1) are arranged in the generating chamber 2. The generating chamber 2 is used for generating multinary nanoparticles (alloy nanoparticles) 9 by mutually combining nanoparticles 8a to 8c of the metal materials 4a to 4c. As the metal materials 4a to 4c, it is possible to use metal wires made of, for example, magnesium and nickel, or metal wires made of alloys of these metal. A coolant-gas introduction unit 10 is attached to the generating chamber 2, and coolant gas is introduced from the coolant-gas introduction unit 10.

An exhaust unit (vacuum fan in FIG. 1) 5 is attached to the film forming chamber 3, and the film forming chamber 3 is vacuumed by the exhaust unit 5 (in the direction of arrow D). The generating chamber 2 is connected to the film forming chamber 3 via a communication pipe 6. As the communication pipe 6, it is possible to use, for example, 1/8 pipe. Therefore, a pressure difference is caused between the generating chamber 2 and the film forming chamber 3. By the pressure difference, the multinary nanoparticles 9 generated in the generating chamber 2 are made to quickly flow into the film forming chamber 3 through the communication pipe 6. A substrate 7 is arranged in the film forming chamber 3, and a film of the multinary nanoparticles 9 is formed on the substrate 7.

In the generating chamber 2, granulation units 11a to 11c are arranged so as to respectively correspond to the metal materials 4a to 4c. The granulation units 11a to 11c are respectively provided with containers 12a to 12c respectively covering the corresponding metal materials 4a to 4c. The container 12a to 12c are respectively provided with outflow ports 13a to 13c from which the nanoparticles 8a to 8c respectively flow out, and with inflow ports 14a to 14c through which coolant gas is introduced. Only the outflow ports 13a to 13c and the inflow ports 14a to 14c are opened. In Figure 1, each of the containers 12a to 12c is formed into a substantially truncated cone shape, in the upper surface of which each of the outflow ports 13a to 13c is formed, and in the lower surface of which each of the inflow ports 14a to 14c is formed. Further, the containers 12a to 12c are respectively provided with heaters 15a to 15c. Each of the metal materials 4a to 4c is evaporated by being heated by each of the heaters 15a to 15c respectively corresponding to the metal materials 4a to 4c, and thereby the nanoparticles 8a to 8c are generated. A crucible, a plasma generator, or the like, can be used as each of the heaters 15a to 15c.

In this way, in the nanoparticle film forming system 1, each of the independent granulation units 11a to 11c is provided for each of the metal materials 4a to 4c respectively arranged in the generating chamber 2. As a result, the nanoparticles 8a to 8c can be obtained in such a manner that each of the metal material 4a to 4c is evaporated under conditions suitable for each of the materials 4a to 4c. Therefore, suitable amounts of nanoparticles 8a to 8c having suitable diameters can be respectively generated from the plurality of metal materials 4a to 4c regardless of the evaporation pressures which are respectively different for the metal materials 4a to 4c and without thermal influence between the metal materials 4a to 4c. Thereby, the multinary nanoparticle film 9 can be formed on the substrate 7.

Further, when the capacity of each of the containers 12a to 12c is optimized for each of the metal materials 4a to 4c, each of the metal materials 4a to 4c can be evaporated at an evaporation pressure suitable for each of the metal materials 4a to 4c. As described above, in FIG. 1, each of the containers 12a to 12c is formed into a substantially truncated cone shape, and the diameter and the longitudinal length of one of the containers 12a to 12c are different from those of the other of the containers 12a to 12c. The capacity of the container covering a metal material with a high evaporation pressure is set to be large. Further, when the distances A to C from the outflow ports 13a to 13c to the communication pipe 6 are respectively optimized for each of the metal materials 4a to 4c, it is possible to adjust the difference between the moving speeds of the metal materials 4a to 4c due to the masses of the metal materials 4a to 4c. When the difference between the moving speeds of the metal materials 4a to 4c can be adjusted, there is a merit that the composition ratio for forming the multinary nanoparticles 9 can be easily adjusted.

In the following, a nanoparticle film forming method using the nanoparticle film forming system 1 described above will be described.

First, a nanoparticle generation process is performed. This process is performed in the generating chamber 2, and more particularly, in each of the granulation units 11a to 11c. Here, the process is described by taking the granulation unit 11a as an example, but the process in each of the granulation units 11b and 11c is also similarly performed. The metal material 4a made of a metal wire is arranged in the container 12a. Then, a coolant gas (a coolant gas containing helium or argon gas) is introduced from the inflow port 14a into the container 12a by driving the coolant-gas introduction unit 10, and the metal material 4a is also heated by the heater 15a. Then, the nanoparticles 8a are obtained by evaporating the metal material 4a. In this way, the nanoparticles 8a are generated in the gas-phase environment, and hence even when the metal material 4a is a metal, such as magnesium, which is easily oxidized, the unnecessary oxidization can be prevented. The generated nanoparticles 8a are made to flow out from the outflow port 13a of the container 12a.

In the nanoparticle generation process, the granulation units 11a to 11c respectively provided for the metal materials 4a to 4c are used as described above, and hence nanoparticles can be generated under optimum conditions for each of the metal materials 4a to 4c. That is, as described above, nanoparticles of each of the metal materials 4a to 4c can be generated by optimizing each of the capacity of the containers 12a to 12c, and by optimizing each of the distances A to C from each of the outflow ports 13a to 13c to the communication pipe 6. Further, since each of the heaters 15a to 15c is independently provided at each of the granulation units 11a to 11c, the heating temperature of each of the metal materials 4a to 4c can be adjusted, and hence each of the metal materials 4a to 4c can be heated at a temperature suitable for each of the metal material 4a to 4c. Further, coolant operation suitable for each of the metal materials 4a to 4c can be performed by changing the introduction amount of the coolant gas introduced into each of the container 12a to 12c. The adjustment of the introduction amount of the coolant gas is performed, for example, in such a manner that the opening area (aperture ratio) of each of the inflow ports 14a to 14c is made different for each of the containers 12a to 12c, and such that an introduction pipe (not shown) leading from the coolant-gas introduction unit 10 to each of the containers 12a to 12c is provided and also a flow control valve (not shown) is provided at the introduction pipe. In Figure 1, the introduction amount of the coolant gas is represented by the size of the arrow. That is, the introduction amount of the coolant gas denoted by arrow E and introduced into the container 12b is the largest, and the introduction amount of the coolant gas denoted by arrow F and introduced into the container 12a is the second largest, and the introduction amount of the coolant gas denoted by arrow G and introduced into the container 12c is the smallest.

Next, an alloying process is performed. This process is performed in the generating chamber 2. Specifically, when the nanoparticles 8a to 8c generated in the granulation units 11a to 11c flow out from the outflow ports 13a to 13c of the respective containers 12a to 12c, the nanoparticles 8a to 8c are combined with each other. Thereby, multinary nanoparticles 9 are generated. The multinary nanoparticles 9 alloyed in this way have a nano-coaxial structure or nano-core-shell structure in each of which fine nanoparticles are combined with each other.

Next, a film forming process is performed. The multinary nanoparticles 9 formed in the alloying process are made to flow into the film forming chamber 3 through the communication pipe 6 by a pressure difference between the film forming chamber 3 and the generating chamber 2. Then, a film of the multinary nanoparticles 9 is formed on the substrate 7 arranged in the film forming chamber 3. When the film of the multinary nanoparticles 9 is fully formed on the substrate 7, then the substrate 7 is exchanged, so that the film forming process is newly performed. As means for moving the substrate 7 at the time of exchanging the substrate 7, the substrate 7 may be fed out while being rolled by a roller, or the substrate 7 may be moved by using a conveying apparatus, such as a roller conveyor. It is also possible that a film of the multinary nanoparticles 9 is formed on the substrate 7 which is being moved by such moving means.

### Explanation of Reference Signs

- 1: Nanoparticle film forming system
- 2: Generating chamber
- 3: Film forming chamber
- 4a to 4c: Metal material
- 5: Exhaust unit
- 6: Communication pipe
- 7: Substrate
- 8a to 8c: Nanoparticles
- 9: Multinary nanoparticles
- 10: Coolant-gas introduction unit
- 11a to 11c: Granulation unit
- 12a to 12c: Container
- 13a to 13c: Outflow port
- 14a to 14c: Inflow port
- 15a to 15c: Heater

## Claims

1. A multinary nanoparticle film forming system comprising:
a generating chamber with a plurality of metal materials arranged therein so as to generate multinary nanoparticles from nanoparticles formed from each of the metal materials;
a film forming chamber with a substrate arranged therein so as to enable a film of the multinary nanoparticles to be formed on the substrate;
a communication pipe configured to connect the generating chamber to the film forming chamber;
an exhaust unit configured to carry out exhaust from the film forming chamber;
a coolant-gas introduction unit configured to introduce coolant gas into the generating chamber; and
granulation units arranged in the generating chamber so as to respectively correspond to the plurality of metal materials,
wherein the granulation unit includes a container covering each of the metal materials, a heater arranged in the container, an outflow port provided at the container so as to enable the nanoparticles to flow out therefrom, and an inflow port provided at the container so as to enable the coolant gas to be introduced into the container.

2. The multinary nanoparticles film forming system according to claim 1, wherein the capacity of the container, and the distance from the outflow port to the communication pipe are different for each of the metal materials.

3. A multinary nanoparticle film forming method using the multinary nanoparticle film forming system according to claim 2, the method comprising:
a nanoparticle generation process of generating nanoparticles from the metal material in each of the granulation units;
an alloying process of generating multinary nanoparticles by combining the plurality of kinds of nanoparticles in the generating chamber; and
a film forming process of passing the multinary nanoparticles through the communication pipe and forming a film of the multinary nanoparticles on the substrate in the film forming chamber.

4. The multinary nanoparticle film forming method according to claim 3, wherein, in the nanoparticle generation process, the heating temperature by the heater, and the amount of the coolant gas introduced into the container are adjusted to be different for each of the metal materials respectively arranged in the granulation units.
